Europäisches Patentamt

European Patent Office

Office européen des brevets

(19)

(11) Veröffentlichungsnummer: **0 192 257**
**A2**

(12) # EUROPÄISCHE PATENTANMELDUNG

(21) Anmeldenummer: **86102170.7**

(22) Anmeldetag: **19.02.86**

(51) Int. Cl.⁴: **H 03 G 3/00**

(30) Priorität: **21.02.85 DE 3505983**
**04.02.86 US 825936**

(43) Veröffentlichungstag der Anmeldung:
**27.08.86 Patentblatt 86/35**

(84) Benannte Vertragsstaaten:
**CH DE FR GB IT LI**

(71) Anmelder: **AUDIO SYSTEM DB AG**
**Münchensteinerstrasse 270**
**CH-4053 Basel(CH)**

(72) Erfinder: **Portmann, Jürg**
**In den Ziegelhöfen 140**
**CH-4054 Basel(CH)**

(74) Vertreter: **Lins, Edgar, Dipl.-Phys. et al,**
**Patentanwälte Gramm + Lins Theodor-Heuss-Strasse 2**
**D-3300 Braunschweig(DE)**

(54) **Schaltungsanordnung zur elektronischen Erzeugung einer Widerstandseinstellung und damit aufgebauter Audio-Anlage.**

(57) Die Erzeugung einer Widerstandseinstellung entsprechend einem vorgegebenen Spannungswert läßt sich ohne Verzerrung, Dynamikbeschneidung oder sonstige Störungen für das durch den Widerstand beeinflußte signal erzielen, wenn ein zwei Eingänge aufweisender Regelkreis (4,12) vorgesehen ist, dessen Eingangssignale sich im eingeregelten Zustand einander entsprechend, wovon ein Eingangssignal durch den vorgegebenen Spannungswert ($U_{DAC}$) gebildet und das zweite Eingangssignal über einem lichtabhängigen Widerstand (6) abnehmbar ist, wenn das Ausgangssignal des Regelkreises (4,12) eine zu dem lichtabhängigen Widerstand (6) gehörende und mit ihm ein Leuchtdioden-Widerstand-Paar (12) bildende Leuchtdiode (10) steuert und wenn das Ausgangssignal des Regelkreises (4,12) die Leuchtdiode eines weiteren Leuchtdioden-Widerstand-Paares (14) steuert, dessen Widerstand (13) somit entsprechend dem vorgegebenen Spannungswert ($U_{DAC}$) eingestellt ist.

EP 0 192 257 A2

./...

Fig.1

# Patentanwälte GRAMM + LINS

Dipl. Ing. Prof. Werner Gramm
Dipl. Phys. Edgar Lins

**0192257**
European Patent Attorneys

AUDIO SYSTEM DB AG
Münchensteinerstraße 270
CH-4053 Basel

Anwaltsakte
721-2 EP-1

Datum
18. Februar 1986

Schaltungsanordnung zur elektronischen Erzeugung einer
Widerstandseinstellung und damit aufgebauter Audio-Anlage

Die Erfindung betrifft eine Schaltungsanordnung zur elektronischen Erzeugung einer Widerstandseinstellung entsprechend einem vorgegebenen Spannungswert. Die Erfindung betrifft insbesondere eine mit einer derartigen Schaltungsanordnung aufgebaute Audioanlage.

Einstellungen von elektrischen variablen Größen werden in der Regel mit variablen Widerständen vorgenommen. Insbesondere bei komplexen Einstellungen einer Mehrzahl von variablen Widerständen besteht häufig der Wunsch, eine einmal vorgenommene Einstellung der variablen Widerstände auch dann sofort wieder reproduzieren zu können, wenn zwischenzeitlich andere Einstellungen vorgenommen werden mußten. Es ist bekannt, die zwischen einem Abgriff und einem Anschluß des variablen Widerstandes abfallende Spannung als Signalwert für die Größe des Widerstands, also die Widerstandseinstellung, in digitaler Form zu speichern. Hierzu wird die analoge Spannung über einen Analog-Digital-Wandler in ein digitales, in handelsüblichen Digitalspeichern abspeicherbares Signal gewandelt. Die Rückwandlung des gespeicherten Signals in ein

Theodor-Heuss-Straße 2
D-3300 Braunschweig    Bundesrepublik Deutschland

Telefon    0531-80079
Telex    0952620 gramm d
Telegrammadresse    Patent Braunschweig

- 2 -

analoges Signal erfolgt üblicherweise über einen Digital-Analog-Wandler, an dessen Ausgang ein analoger Spannungs-wert steht. Dieser Spannungswert kann auf einen Eingang eines spannungsgesteuerten Verstärkers gegeben werden, der eine auf ihn geleitete Spannung in Abhängigkeit von dem Spannungswert am Ausgang des Digital-Analog-Wandlers verstärkt und eine der Widerstandseinstellung entsprechende Beeinflussung vornimmt.

Die Verwendung von spannungsgesteuerten Verstärkern ist nicht nur sehr aufwendig und teuer, sondern führt, insbesondere bei der Hintereinanderschaltung einer Mehrzahl derartiger Verstärker, zu einem, beispielsweise bei Audio-Anlagen, nicht mehr tolerierbaren Rauschen, zu einer Einschränkung der Dynamik der verarbeiteten Signale sowie zu Verzerrungen aufgrund von Nichtlinearitäten.

Für komplexe Anlagen mit einer Vielzahl von Einstellreglern, wie beispielsweise einem 28-kanaligen Mischpult, ist daher die Abspeicherung von momentanen Widerstandswerten praktisch nicht möglich.

Ein weiterer Nachteil der bekannten Schaltungsanordnung besteht darin, daß eine Veränderung der Widerstandseinstellung während einer hochfrequenten Abfrage mit Hilfe eines Mikroprozessors am Ausgang des Digital-Analog-Wandlers eine treppenförmige Veränderung der Ausgangsspannung verursacht, die aufgrund der enthaltenen Oberwellenanteile bei Audio-Anlagen zu störenden Geräuschen führt, wenn nicht besondere aufwendige Maßnahmen ergriffen werden.

Der Erfindung liegt daher die Aufgabe zugrunde, eine Schaltungsanordnung der eingangs erwähnten Art zu erstellen, die weder das durch die Widerstandseinstellung zu beeinflussende Signal hörbar verzerrt noch eine Verschlechterung bezüglich des Signal-Rausch-Verhältnisses oder bezüglich der Dy- namik mit sich bringt.

Diese Aufgabe wird erfindungsgemäß dadurch gelöst, daß ein zwei Eingänge aufweisender Regelkreis vorgesehen ist, dessen Eingangssignale sich im eingeregelten Zustand einander entsprechen, wovon ein Eingangssignal durch den vorgegebenen Spannungswert gebildet und das zweite Eingangssignal über einem lichtabhängigen Widerstand abnehmbar ist, daß das Ausgangssignal des Regelkreises eine zu dem lichtabhängigen Widerstand gehörende und mit ihm ein Leuchtdioden-Widerstand-Paar bildende Leuchtdiode steuert und daß das Ausgangssignal des Regelkreises die Leuchtdiode eines weiteren Leuchtdioden-Widerstand-Paares steuert, dessen Widerstand somit entsprechend dem vorgegebenen Spannungswert eingestellt ist.

Die Erfindung beruht auf der Verwendung von handelsüblichen Leuchtdioden-Widerstand-Paaren, die auch als LDR (light dependent resistors) bezeichnet werden. Der Wert des Widerstands ist abhängig von der Stromstärke, die durch die Leuchtdiode fließt. Da die Kopplung zwischen Leuchtdiode und dem Widerstand über das von der Leuchtdiode ausgesandte Licht erfolgt, sind Leuchtdiode und Widerstand galvanisch voneinander getrennt. Erfindungsgemäß wird nun ein Widerstand eines derartigen Leuchtdioden-Widerstand-Paares mit einem Festwiderstand zu einem Spannungsteiler kombiniert, dessen Verbindungspunkt zwischen den beiden Widerständen mit einem Eingang eines Regelkreises verbunden ist. An den anderen Eingang gelangt das Signal mit dem vorgegebenen Spannungswert, also im allgemeinen das Ausgangssignal eines Digital-Analog-Wandlers. Der vorzugsweise mit einem Operationsverstärker aufgebaute Regelkreis stellt das Licht der Leuchtdiode so ein, daß der von der Leuchtdiode abhängige Widerstand eine Größe annimmt, die das Signal an dem zweiten Eingang des Operationsverstärkers gleich dem vorgegebenen Spannungswert werden läßt. Die Größe des von der Leuchtdiode gesteuerten Widerstands ist also unmittelbar ein Abbild der Größe des Spannungswertes. Erfindungsgemäß ist ein zweites Leuchtdioden-Widerstand Paar vorgesehen, dessen Leuchtdiode mit dem Steuerstrom für die Leuchtdiode des ersten Leuchtdioden-Widerstand-Paares angesteuert wird. Der zu dem zweiten Leuchtdioden-Widerstand-Paar gehörende Widerstand nimmt somit die gleiche Größe wie der im Regelkreis befindliche Widerstand des ersten Leuchtdioden-Widerstand-Paares an und ist darüber hinaus vom Regelkreis vollständig galvanisch getrennt. Für die Signalverarbeitung mit der gewünschten Widerstandseinstellung wird daher lediglich der Ohmsche Widerstand des zweiten Leuchtdioden-Widerstand-Paares benutzt. Der Ohmsche Widerstand kann als rein passives Schaltelement weder Verzerrungen noch ein merkliches Rauschen verursachen. Ein weiterer Vorteil der Verwendung von Leuchtdioden-Widerstand-Paaren besteht darin, daß die Anpassung des Widerstandswertes an einen Steuerstrom mit einer gewissen Trägheit geschieht, die eine Integrationswirkung ausübt. Die bei der dynamischen Veränderung der Widerstandseinstellung auftretende Treppenspannung am Ausgang des Digital-Analog-Wandlers wird dadurch zu einer stetigen Kurve verschliffen. Durch Oberwellen entstehende störende Geräusche können somit vermieden werden.

Durch die Erfindung ist es erstmalig möglich, die Reproduktion einer Widerstandseinstellung an einem galvanisch von der Regelschaltung getrennten Ohmschen Widerstand vorzunehmen.

Da die Trägheit des Leuchtdioden-Widerstand-Paares zu Schwingvorgängen im Regelkreis führen könnte, ist es vorteilhaft, wenn der Regelkreis ein Integrationsglied enthält, dessen Zeitkonstante der Trägheit des Leuchtdioden-Widerstand-Paares entspricht.

Der Widerstandsverlauf von Leuchtdioden-Widerstand-Paaren in Abhängigkeit von dem Steuerstrom ist in der Kurvenform ausreichend identisch, kann aber parallelverschoben sein.

Um den gleichen Widerstandwert für den Widerstand im Regelkreis und den Widerstand an den Ausgangsklemmen der Schaltungsanordnung zu erzielen, kann ein Symmetrierungswiderstand vorgesehen sein, auf dessen Abgriff der Steuerstrom für die Leuchtdioden gelangt. Damit ist die möglicherweise erforderliche relative Parallelverschiebung der Kennlinien der Widerstände durchführbar.

In einer alternativen Ausführungsform kann der Steuerstrom für die zweite Leuchtdiode über einen einstellbaren Linearverstärker einstellbar sein, wodurch ebenfalls die Parallelverschiebung möglich ist.

In einer einfachen Ausführungsform der erfindungsgemäßen Schaltung ist das zweite Eingangssignal am Abgriff eines aus einem Festwiderstand und dem lichtabhängigen Widerstand gebildeten Spannungsteilers abnehmbar.

In einer bevorzugten alternativen Ausführungsform ist mit dem lichtabhängigen Widerstand eine Konstantstromquelle verbunden und das zweite Eingangssignal ist zwischen der Konstantstromquelle und dem lichtabhängigen Widerstand abnehmbar. Da der Strom konstant bleibt, ist bei dieser Schaltungsanordnung sichergestellt, daß sich die Spannung linear proportional mit dem Widerstand ändert, so daß ein lineares Regelverhalten erzielt wird.

Es ist auch möglich, die Eingangssignale auf einen Eingang der Regelschaltung zu legen, während der andere Eingang an einem Bezugspotential, im allgemeinen Masse, liegt. Ein besonderes Regelverhalten läßt sich erzielen, wenn den beiden Eingangsspannungen eine Offsetspannung umgekehrter Polarität zugefügt wird. In diesem Fall ist der Widerstand im Ausgang der Schaltung umgekehrt proportional zu dem das erste Eingangssignal bildenden Spannungswert.

Die erfindungsgemäße Schaltungsanordnung erlangt eine besonders hohe Bedeutung als Teil einer Audio-Anlage mit einer Vielzahl von variablen Widerständen regelnden Einstellreglern, einer Speicherstufe für die über die variablen Widerstände momentan abfallenden Spannungswerte und einer Stufe zur Reproduktion der den eingestellten variablen Widerständen entsprechenden Widerstandswerte. Erfindungsgemäß wird bei einer derartigen Audio-Anlage die über dem variablen Widerstand abfallende Spannung mittels eines Mikroprozessors abgefragt und in digitaler Form abgespeichert und die Reproduktion durch den Mikroprozessor gesteuert und erfolgt über einen Digital-Analog-Wandler, an den ein zwei Eingänge aufweisender Regelkreis vorgesehen ist, dessen Eingangssignale sich im eingeregelten Zustand einander entsprechen, wovon ein Eingangssignal durch den vorgegebenen Spannungswert und das zweite Eingangssignal über einem lichtabhängigen Widerstand abnehmbar ist, wobei das Ausgangssignal des Regelkreises eine zu dem lichtabhängigen Widerstand gehörende und mit ihm ein Leuchtdioden-Widerstand-Paar bildende Leuchtdiode steuert und das Ausgangssignal des Regelkreises die Leuchtdiode eines weiteren Leuchtdioden-Widerstand-Paares steuert, dessen Widerstand somit entsprechend dem vorgegebenen Spannungswert eingestellt ist.

Die Erfindung soll im folgenden anhand von in der Zeichnung dargestellten Ausführungsbeispielen näher erläutert werden. Es zeigen:

Figur 1 - eine Audio-Anlage mit einem Potentiometer, dessen Einstellwert elektronisch reproduziert wird;

Figur 2 - eine zweite Ausführungsform der Schaltung gemäß Figur 1;

Figur 3 - eine alternative Schaltungsanordnung mit einer Konstantstromquelle;

Figur 4 - eine Schaltungsanordnung mit einer Teilschaltung gemäß Figur 3 und einer weiteren Teilschaltung, bei der die Eingangssignale auf einen gemeinsamen Eingang des Regelkreises addiert werden;

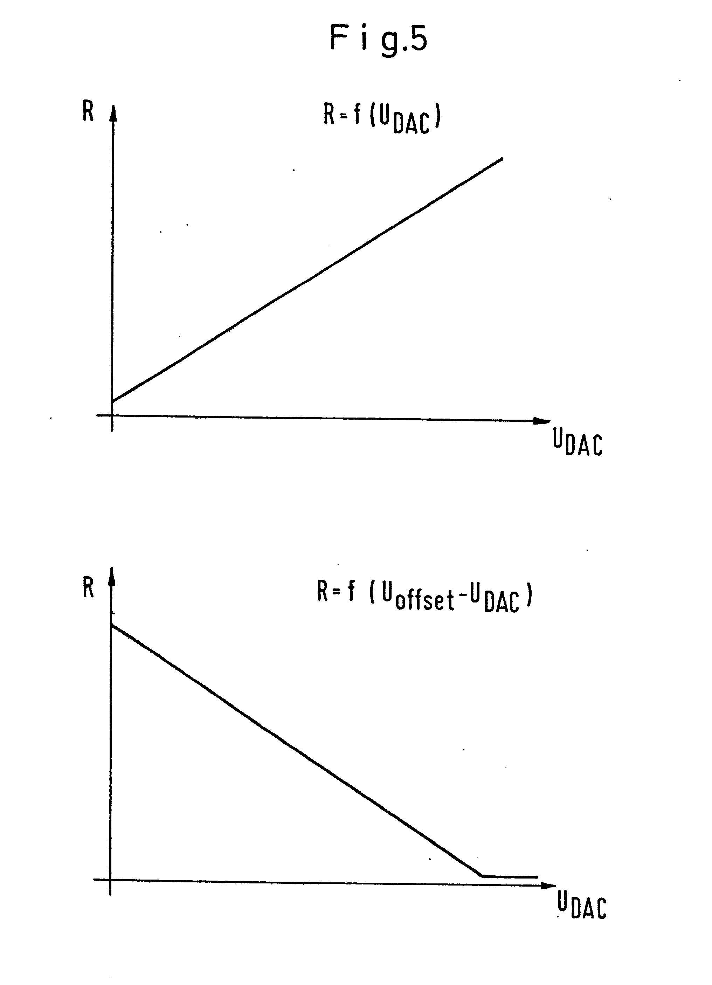

Figur 5 - graphische Darstellungen der Regelverhalten der beiden Teilschaltungen aus Figur 4.

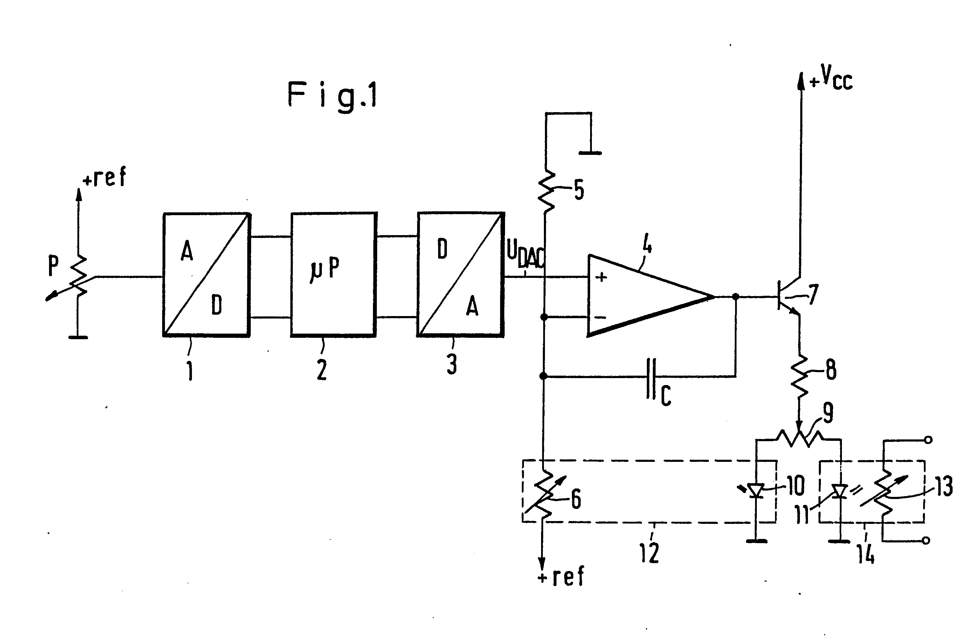

Figur 1 zeigt ein Potentiometer P, dessen beide Enden an den beiden Polen einer Referenzspannung +ref, Masse liegt. Somit ergibt sich der Einstellwert des Potentiometers P als am Abgriff des Potentiometers abnehmbare Analogspannung. Diese wird über einen Analog-Digital-Wandler 1 in ein digitales Signal umgewandelt, das mit Hilfe eines Mikroprozessors 2 abgefragt und abgespeichert wird.

Soll die abgespeicherte Potentiometereinstellung reproduziert werden, liest der Mikroprozessor 2 das digitale Signal aus dem Speicher aus und leitet es auf einen Digital-Analog-Wandler 3, an dessen Ausgang somit eine analoge Spannung U

$U_{DAC}$ ansteht. Diese Spannung gelangt auf den nicht invertierenden Eingang eines Operationsverstärkers 4, dessen invertierender Eingang mit dem Verbindungspunkt eines aus einem Festwiderstand 5 und einem lichtabhängigen Widerstand 6 gebildeten Spannungsteilers 5,6 angeschlossen ist. Der Spannungsteiler 5,6 ist zwischen die Klemmen der Referenzspannung +ref geschaltet. Der Ausgang des Operationsverstärkers 4 ist über einen Integrationskondensator $C_{int}$ in Serie mit einem Widerstand $R_{int}$ mit dem invertierenden Eingang verbunden.

Das Ausgangssignal des Operationsverstärkers 4 gelangt über einen als Emitterfolger geschalteten Transistor 7 und einen an den Emitter des Transistors 7 angeschlossenen Serienwiderstand 8 auf den Abgriff eines Symmetrierwiderstands 9. An die beiden Anschlüsse des Symmetrierwiderstands 9 sind Leuchtdioden 10,11 angeschlossen, deren Katoden an Masse liegen. Die Leuchtdiode 10 bildet mit dem lichtabhängigen Widerstand 6 ein Leuchtdioden-Widerstand-Paar 12, während die Leuchtdiode 11 mit einem weiteren lichtabhängigen Widerstand 13 ein Leuchtdioden-Widerstand-Paar 14 bildet.

Die Wirkungsweise der dargestellten Schaltung beruht darauf, daß die Leuchtdiode 10 den zugehörigen lichtabhängigen Widerstand 6 so steuert, daß die Spannungen an den beiden Eingängen des Operationsverstärkers 4 gleich groß sind. Da die Leuchtdiode 11 des Leuchtdioden-Widerstand-Paares 14 mit dem gleichen, durch den Emitterfolger 7 fließenden Strom angesteuert wird, stellt sich der Widerstand 13 dieses Leuchtdioden-Widerstand-Paares 14 auf den gleichen Wert ein wie der Widerstand 6 des ersten Leuchtdioden-Widerstand-Paares 12. Eventuelle Parallelverschiebungen der Strom-Widerstands-Kennlinie der beiden Leuchtdioden-Widerstand-Paare 12 und 14 relativ zueinander können durch einen Abgleich an dem Symmetrierwiderstand 9 ausgeglichen werden. Das Integrationsglied $C_{int}$, $R_{int}$ stellt die Regelkonstante des Regelkreises auf die Trägheit der Anpassung der Widerstände 6,13 auf die durch die zugehörigen Leuchtdioden 10,11 fließenden Ströme ein und verhindert somit das Auftreten von Schwingungen im Regelkreis.

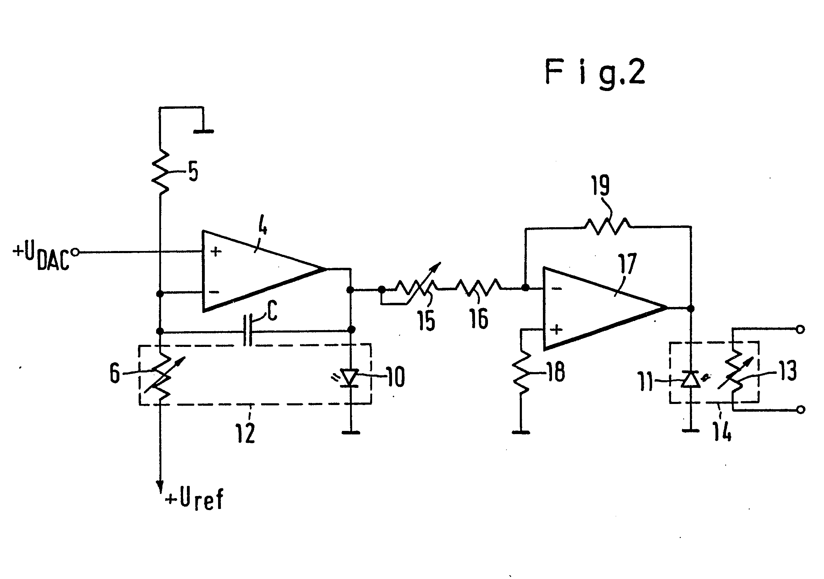

Anstelle des Symmetrierwiderstands 9 kann die relative Anpassung der beiden Widerstände 6,13 aufeinander auch durch einen linearen Verstärker erfolgen. Diese Ausführungsform ist in Figur 2 dargestellt, in der die Bauteile, die mit den Bauteilen in Figur 1 identisch sind, die gleichen Bezugsziffern tragen. Der Ausgang des Operationsverstärkers 4 ist hierbei mit der Serienschaltung eines einstellbaren Widerstands 15 und eines Festwiderstands 16 verbunden, dessen anderes Ende mit dem invertierenden Eingang eines Operationsverstärkers 17 verbunden ist. Der nicht invertierende Eingang des Operationsverstärkers 17 liegt über einen Festwiderstand 18 an Masse. Der Ausgang des Operationsverstärkers 17 ist zur Linearisierung der Verstärkerkennlinie über einen Festwiderstand 19 auf den invertierenden Eingang gegengekoppelt. Der Ausgang des Operationsverstärkers 17 ist weiterhin mit der Katode der Leuchtdiode 11 des zweiten Leuchtdioden-Widerstand-Paares 14 verbunden, deren Anode an Masse liegt. Die Leuchtdiode 11 steuert in der gleichen Weise wie in Figur 1 den Widerstand 13.

An die Klemmen des Widerstands 13 sind die Teile der Schaltung anschaltbar, die über den mit dem Potentiometer P verbundenen Einstellregler gesteuert werden. Die abgespeicherte Stellung des Einstellreglers wird durch den Widerstand 13 zuverlässig reproduziert. Das normalerweise durch ein mit dem Einstellregler verbundenes Potentiometer beeinflußte elektrische Signal, vorzugsweise Audiosignal, läßt sich in der gleichen Weise durch den Widerstand 13 beeinflussen, ohne daß es hierdurch zu einer Vergrößerung des Rauschens, zu einer Verzerrung der Signale oder zu einer Einengung des Dynamikbereichs käme, da die Beeinflussung des Signals ausschließlich über einen von der Regelschaltung galvanisch ge- trennten Ohmschen Widerstand erfolgt.

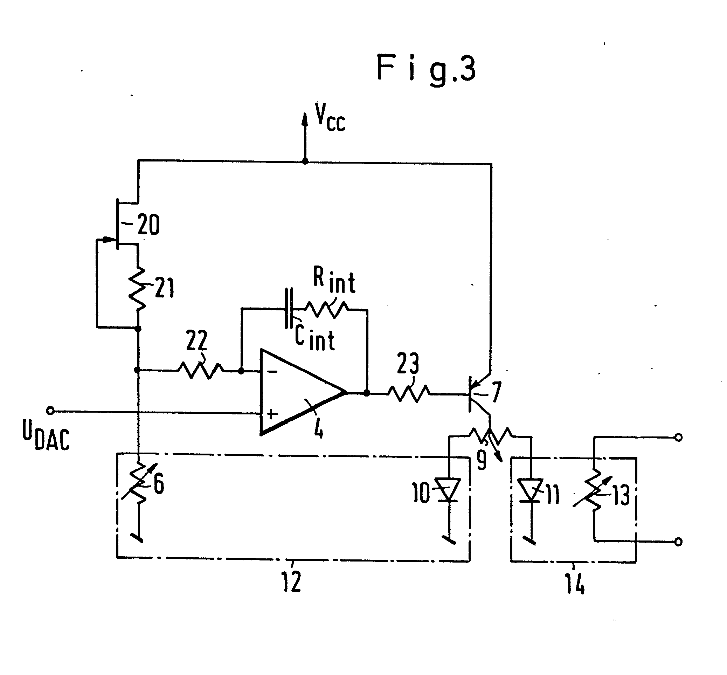

Figur 3 zeigt eine Schaltungsanordnung, bei der der lichtabhängige Widerstand an die Spannungsquelle $V_{cc}$ über eine aus
einem Feldeffekttransistor 20 und einem Serienwiderstand 21
gebildete Konstantstromquelle angeschlossen ist. Das nicht
mit dem Feldeffekttransistor 20 verbundene Ende des Widerstands 21 ist mit dem Gate des Feldeffekttransisitors 20
verbunden. Diese den Strom durch den lichtabhängigen Widerstand 6 konstant haltende Schaltungsanordnung sorgt dafür,
daß Widerstandswert und Spannung einen strenglinearen Zusammenhang aufweisen, da beim Ohmschen Gesetz $R = \dfrac{U}{I}$ der Strom I
konstant ist. Der Verbindungspunkt zwischen der Konstantstromquelle 20,21 und dem lichtabhängigen Widerstand 6 ist
über einen Widerstand mit dem invertierenden Eingang des
Operationsverstärkers 4 verbunden. Der Transistor 7 ist in
diesem Fall als pnp-Transistor ausgebildet. Alle übrigen
Teile der Schaltung sind identisch und weisen daher identische Bezugsziffern auf.

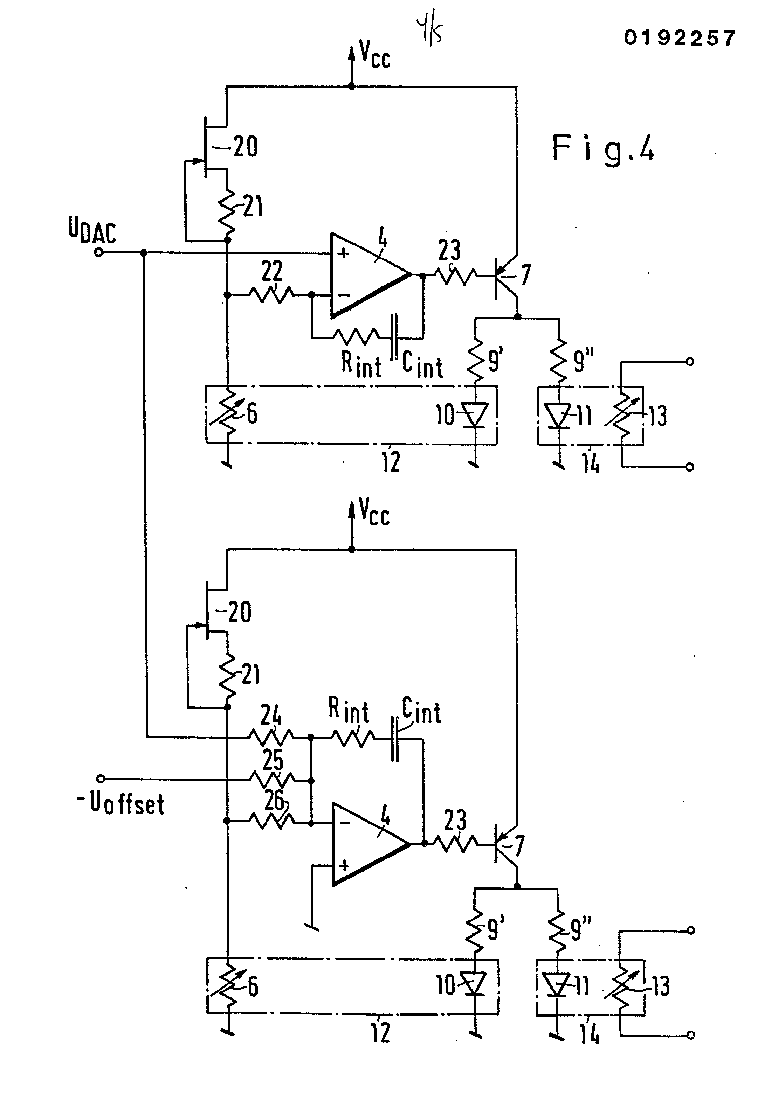

Figur 4 zeigt eine Schaltungsanordnung, die im oberen Teil
mit der Schaltungsanordnung aus Figur 3 identisch ist. Auch
der untere Teil der Schaltungsanordnung ist mit der Schaltung gemäß Figur 3 weitgehend identisch. Ein Unterschied
besteht lediglich darin , daß die Eingangsspannungen $U_{DAC}$
und die über dem lichtabhängigen Widerstand 6 stehende Spannung über Entkopplungswiderstände 24,26 addiert dem invertierenden Eingang des Operationsverstärkers 4 zugeführt werden, während der positive Eingang des Operationsverstärkers
4 an Masse liegt. Zusätzlich zu den beiden addierten Eingangsspannungen wird eine negative Offsetspannung $-U_{offset}$
über einen weiteren Entkopplungswiderstand 25 zugeführt.
Während dam Ausgangswiderstand 13 im oberen Teil der Schaltung eine lineare Abhängigkeit zwischen der Eingangsspannung $U_{DAC}$ und dem Widerstand R besteht, wie dies in Figur
5a dargestellt ist, ist die Größe des Widerstands im unteren Teil der Schaltung abhängig von der Differenz zwischen der Offsetspannung $U_{offset}$ und der Eingangsspannung $U_{DAC}$. Hieraus ergibt sich bei ansteigender Eingangsspannung $U_{DAC}$ eine Verkleinerung des Widerstands der lichtabhängigen Widerstände 6 und 13, so daß sich eine umgekehrte Proportionalität ergibt. Für die Eingangsspannung $U_{DAC}$ = 0 bestimmt sich der Widerstandswert allein durch die Offsetspannung. Der Widerstandswert wird minimal, wenn die Eingangsspannung gleich der Offsetspannung ist. In einfacher Weise lassen sich daher unterschiedliche Regelcharakteristiken über die Zuführung von konstanten Eingangsspannungen erzeugen.

Li/bk

**Patentanwälte GRAMM + LINS**

Dipl.-Ing. Prof. Werner Gramm
Dipl.-Phys. Edgar Lins

**0192257**

European Patent Attorneys

AUDIO SYSTEM DB AG
Münchensteinerstraße 270
CH-4053 Basel

Anwaltsakte
721-2 EP-1

Datum
18. Februar 1986

Patentansprüche:

1. Schaltungsanordnung zur elektronischen Erzeugung einer Widerstandseinstellung entsprechend einem vorgegebenen Spannungswert ($U_{DAC}$), dadurch gekennzeichnet, daß ein zwei Eingänge aufweisender Regelkreis (4,12) vorgesehen ist, dessen Eingangssignale sich im eingeregelten Zustand einander entsprechen, wovon ein Eingangssignal durch den vorgegebenen Spannungswert ($U_{DAC}$) gebildet und das zweite Eingangssignal über einem lichtabhängigen Widerstand (6) abnehmbar ist, daß das Ausgangssignal des Regelkreises (4,12) eine zu dem lichtabhängigen Widerstand (6) gehörende und mit ihm ein Leuchtdioden-Widerstand-Paar (12) bildende Leuchtdiode (10) steuert und daß das Ausgangssignal des Regelkreises (4,12) die Leuchtdiode eines weiteren Leuchtdioden-Widerstand-Paares (14) steuert, dessen Widerstand (13) somit entsprechend dem vorgegebenen Spannungswert ($U_{DAC}$) eingestellt ist.

2. Schaltungsanordnung nach Anspruch 1, dadurch gekennzeichnet, daß der Regelkreis (4,12) ein Integrationsglied ($C_{int}$, $R_{int}$) enthält, dessen Zeitkonstante der Trägheit des Leuchtdioden-Widerstand-Paares (12) entspricht.

- 2 -

3. Schaltungsanordnung nach Anspruch 1 oder 2, dadurch gekennzeichnet, daß der Regelkreis durch einen Operationsverstärker (4) gebildet ist, dessen beide Eingänge bzw. dessen Ausgang die beiden Eingänge bzw. den Ausgang des Regelkreises bilden.

4. Schaltungsanordnung nach einem der Ansprüche 1 bis 3, dadurch gekennzeichnet, daß der Steuerstrom für die Leuchtdioden (10,11) auf den Abgriff eines Symmetrierungswiderstands (9) gelangt, an dessen beiden Enden jeweils eine der beiden Leuchtdioden (10,11) angeschlossen ist.

5. Schaltungsanordnung nach einem der Ansprüche 1 bis 3, dadurch gekennzeichnet, daß der Steuerstrom für die zweite Leuchtdiode (11) über einen einstellbaren Linearverstärker (15 - 19) einstellbar ist.

6. Schaltungsanordnung nach Anspruch 5, dadurch gekennzeichnet, daß der Linearverstärker einen das Eingangssignal variierenden einstellbaren Widerstand (15) aufweist.

7. Schaltungsanordnung nach Anspruch 6, dadurch gekennzeichnet, daß der Linearverstärker hinter dem einstellbaren Widerstand (15) durch einen gegengekoppelten Operationsverstärker (17) gebildet ist.

8. Schaltungsanordnung nach Anspruch 1, dadurch gekennzeichnet, daß das zweite Eingangssignal an einem Abgriff eines aus einem Festwiderstand (5) und dem lichtabhängigen Widerstand (6) gebildeten Spannungsteilers abnehmbar ist.

9. Schaltungsanordnung nach einem der Ansprüche 1 bis 6, dadurch gekennzeichnet, daß das zweite Eingangssignal zwischen einer Konstantstromquelle (20,21) und dem lichtabhängigen Widerstand (6) abnehmbar ist.

10. Schaltungsanordnung nach einem der Ansprüche 1 bis 9, dadurch gekennzeichnet, daß die beiden Eingangssignale in addierter Form auf einen Eingang des Regelkreises (4,12) gelangen und daß der andere Eingang des Regelkreises (4,12) an einer Bezugsspannung liegt.

11. Schaltungsanordnung nach Anspruch 10, dadurch gekennzeichnet, daß zu den beiden Eingangssignalen eine Offsetspannung umgekehrter Polarität ($-U_{offset}$) addiert wird.

12. Audio-Anlage mit einer Vielzahl von variablen Widerständen (P) regelnden Einstellreglern, einer Speicherstufe (2) für die über die variablen Widerstände (P) momentan abfallenden Spannungswerte und einer Stufe zur Reproduktion der den eingestellten variablen Widerständen (P) entsprechenden Widerstandswerte, dadurch gekennzeichnet, daß die über dem variablen Widerstand abfallende Spannung mittels eines Mikroprozessors (2) abgefragt und in digitaler Form abgespeichert wird, daß die Reproduktion durch den Mikroprozessor (2) gesteuert über einen Digital-Analog-Wandler (3) erfolgt, an den ein zwei Eingänge aufweisender Regelkreis (4,12) vorgesehen ist, dessen Eingangssignale sich im eingeregelten Zustand einander entsprechen, wovon ein Eingangssignal durch den vorgegebenen Spannungswert ($U_{DAC}$) und das zweite Eingangssignal über einem lichtabhängigen Widerstand (6) abnehmbar ist, daß das Ausgangssignal des Regelkreises (4,12) eine zu dem lichtabhängigen Widerstand (6) gehörende und mit ihm ein Leuchtdioden-Widerstand-Paar (12) bildende Leuchtdiode (10) steuert und daß das Ausgangssignal des Regelkreises (4,12) die Leuchtdiode eines weiteren Leuchtdioden-Widerstand-Paares (14) steuert, dessen Widerstand (13) somit entsprechend dem vorgegebenen Spannungswert ($U_{DAC}$) eingestellt ist.

Patentanwälte

G r a m m   +   L i n s
Li/bk

Fig.1

0192257

# F i g.2

# F i g.3

Fig.4

0192257

0192257

# Fig.5

$R = f(U_{DAC})$

$R = f(U_{offset} - U_{DAC})$